(19) Europäisches Patentamt
European Patent Office
Office européen des brevets

(11) EP 3 570 433 B1

(12) EUROPEAN PATENT SPECIFICATION

(45) Date of publication and mention
of the grant of the patent:
23.06.2021 Bulletin 2021/25

(51) Int Cl.:
H03F 1/02 (2006.01)          H03F 1/56 (2006.01)
H03F 3/60 (2006.01)          H03F 1/42 (2006.01)
H03F 3/24 (2006.01)

(21) Application number: 19184125.3

(22) Date of filing: 18.12.2015

(54) DOHERTY AMPLIFIER

DOHERTY-VERSTÄRKER

AMPLIFICATEUR DE DOHERTY

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 09.01.2015 JP 2015003565

(43) Date of publication of application:
20.11.2019 Bulletin 2019/47

(62) Document number(s) of the earlier application(s) in accordance with Art. 76 EPC:
15201129.2 / 3 043 469

(73) Proprietor: Kabushiki Kaisha Toshiba
Minato-ku
Tokyo 105-8001 (JP)

(72) Inventors:
• Takagi, Kazutaka
Tokyo (JP)
• Tomita, Naotaka
Kanagawa-ken (JP)

(74) Representative: Hoffmann Eitle
Patent- und Rechtsanwälte PartmbB
Arabellastraße 30
81925 München (DE)

(56) References cited:
WO-A1-2013/133215      JP-A- 2006 148 780
JP-A- 2009 165 037      US-A1- 2013 127 528

• MOHAMMADHASSAN AKBARPOUR ET AL: "A 60GHz CMOS class C amplifier intended for use in Doherty architecture", WIRELESS INFORMATION TECHNOLOGY AND SYSTEMS (ICWITS), 2012 IEEE INTERNATIONAL CONFERENCE ON, IEEE, 11 November 2012 (2012-11-11), pages 1-4, XP032312448, DOI: 10.1109/ICWITS.2012.6417733 ISBN: 978-1-4673-0947-9
• R. K. Rao Yarlagadda: "Analog and Digital Signals and Systems" In: "Analog and Digital Signals and Systems", 5 October 2010 (2010-10-05), XP055580656, ISBN: 978-1-4419-0034-0

EP 3 570 433 B1

**Description**

CROSS-REFERENCE TO RELATED APPLICATION

This application is based upon and claims the benefit of priority from Japanese Patent Application No. 2015-003565, filed January 9, 2015.

FIELD

Embodiments described herein relate generally to a Doherty amplifier and a corresponding method.

BACKGROUND

In a system such as quadrature amplitude modulation, which uses a modulation signal having a high peak power with respect to an average power, although meeting specifications for distortion requires sufficient back-off for the amplifier, if the back-off is large in general amplifiers such as class AB amplifiers, the efficiency is reduced. Given this, the Doherty amplifier has been known as an amplifier having high efficiency at a large back-off

The Doherty amplifier includes a carrier amplifier and a peak amplifier connected in parallel and outputs a signal that is the combining of the high frequency signals amplified by the carrier amplifier and the peak amplifier. By having an impedance inverting circuit (IIN: impedance inverting network), the Doherty amplifier achieves a high efficiency when there is a back-off.

There are two types of Doherty amplifiers which are parallel-connected load type and series-connected load type amplifiers. An inverted Doherty amplifier has also been known as a Doherty amplifier. The inverted Doherty amplifier is a parallel-connected load type having an odd number of IINs on the output side of the carrier amplifier and an even number of IINs on the output side of the peak amplifier. An amplifier that integrates a Doherty amplifier and an inverted Doherty amplifier has been conventionally known.

In this Doherty amplifier, however, because the load admittance or load impedance is a pure conductance or pure resistance, although the efficiency is high at a specific frequency, there has been a possibility of the efficiency decreasing away from that specific frequency.

An example of series-connected load type Doherty amplifier is present in document WO 2013/133215 A1.

The book by YARLAGADDA R.K. RAO: "Analog and Digital Signals and Systems" Springer Science & Business Media, 5 October 2010, ISBN: 978-1-4419-0034-0, provides on page 273 an overview of the circuit parameter models which are available for a two port network, including the F parameters, which are also known as ABCD parameters, or transmission parameters, or cascade parameters, and which are considered by the present invention.

BRIEF DESCRIPTION OF THE DRAWINGS

FIG. 1 is a block diagram showing the parallel-connected load type constitution of a Doherty amplifier as an embodiment not covered by the claimed invention.

FIG. 2 shows an equivalent circuit of the output side of the parallel-connected load type Doherty amplifier of the embodiment not covered by the claimed invention.

FIG. 3 is a circuit diagram showing a part of the parallel-connected load type constitution in the Doherty amplifier of the embodiment not covered by the claimed invention.

FIG. 4 shows the setting of the circuit elements included in the parallel-connected load type Doherty amplifier in the embodiment not covered by the claimed invention.

FIG. 5 shows the relationship, in the Doherty amplifier of the embodiment not covered by the claimed invention, at each back-off value, between the frequency (f/fo) and the combined loss Lc=10 $\times$ $\log_{10}$ (ideal Pot/calculated Pot), which is defined by the ratio of the ideal and calculated total output power Pot.

FIG. 6 is a Smith chart (impedance chart) showing the load impedance ZL'=1/YL' between the load RL side and the combiner in the Doherty amplifier of the embodiment not covered by the claimed invention.

FIG. 7 is a drawing showing the frequency characteristics of a Doherty amplifier of a comparison example.

FIG. 8 is a Smith chart showing the load impedance ZL' in a Doherty amplifier of the comparison example.

FIG. 9 is a block diagram showing the series-connected load type constitution of a Doherty amplifier of an embodiment according to the claimed invention.

FIG. 10 shows an equivalent circuit of the output side of the series-connected load type Doherty amplifier of the embodiment according to the claimed invention.

FIG. 11 shows a basic equivalent circuit of a parallel-connected load type Doherty amplifier of a comparison example.

FIG. 12 shows the relationship between the reference input power, the normalized total output power, the output power of the carrier amplifier, and the output power of the peak amplifier.

FIG. 13 is a basic equivalent circuit of the series-connected load type Doherty amplifier of the comparison example.

A Doherty amplifier according to the invention is defined in independent claim 1. A corresponding method is defined in independent claim 2. A Doherty amplifier may include, but is not limited to, an input terminal, an output terminal a splitter, a combiner, a carrier amplifier, a peak amplifier. The splitter is connected to the input terminal, and the splitter having first and second outputs. The combiner is connected to the output terminal, and the combiner having first and second inputs. The carrier amplifier includes a first input-side two-port network connected to the first output of the splitter, a first amplifier connected to an output of the first input-side two-port network, and a first output-side two-port network connected between an output of the first amplifier and the first input of the combiner. The peak amplifier includes a second input-side two-port network connected to the second output of the splitter, a second amplifier connected to the output of the second input-side two-port network, and a second output-side two-port network connected between an output of the second amplifier and the second input of the combiner. The combiner is a parallel-connected load type having a parallel connection of the output-side two-port network of the carrier amplifier and the output-side two-port network of the peak amplifier for the output terminal at a combining point. The load admittance at the combining point is expressed using a complex number.

If the load admittance at the combining point is YL', the circuit parameters of the output-side two-port network from the current source end of the carrier amplifier up to the combining point are Fc (Ac, Bc, Cc, Dc), the circuit parameters of the output-side two-port network from the current source end of the peak amplifier up to the combining point are Fp (Ap, Bp, Cp, Dp), the load resistance of the carrier amplifier in the state in which it is not backed off is Roptc, the load resistance of the peak amplifier in the state in which it is not backed off is Roptp, m=1+Roptc/Roptp, and the phase difference between the phase of the current source of the carrier amplifier and the phase of the current source of the peak amplifier is θ, within a band of the received signal that is the target for the local device, the relationships:

$$(1) \quad (Ac \times Dp + Bc \times Cp + Bc \times Dp \times YL')/(Cc \times Dp + Cp \times Dc + Dc \times Dp \times YL') = m \times Roptc$$

$$(2) \quad \Delta c/(Cc \times Dp + Cp \times Dc + Dc \times Dp \times YL') = -Roptc \times e^{j\times\theta}$$

$$(3) \quad \Delta p/(Cc \times Dp + Cp \times Dc + Dc \times Dp \times YL') = Roptc \times e^{-j\times\theta},$$

and

$$(4) \quad (Ap \times Dc + Bp \times Cc + Bp \times Dc \times YL')/(Cc \times Dp + Cp \times Dc + Dc \times Dp \times YL') = 0$$

are satisfied, where $\Delta c = Ac \times Dc - Bc \times Cc$ and $\Delta p = Ap \times Dp - Bp \times Cp$.

A Doherty amplifier may include, but is not limited to, an input terminal, an output terminal a splitter, a combiner, a carrier amplifier, a peak amplifier. The splitter is connected to the input terminal, and the splitter having first and second outputs. The combiner is connected to the output terminal, and the combiner having first and second inputs. The carrier amplifier includes a first input-side two-port network connected to the first output of the splitter, a first amplifier connected to an output of the first input-side two-port network, and a first output-side two-port network connected between an output of the first amplifier and the first input of the combiner. The peak amplifier includes a second input-side two-port network connected to the second output of the splitter, a second amplifier connected to the output of the second input-side two-port network, and a second output-side two-port network connected between an output of the second amplifier and the second input of the combiner. The combiner is a series-connected load type, having a series connection of the output-side two-port network of the carrier amplifier and the output-side two-port network of the peak amplifier for the output terminal at a combining point. The load impedance at the combining point is expressed using a complex number.

If the load impedance at the combining point is ZL', the circuit parameters of the output-side two-port network from the current source end of the carrier amplifier up until the combining point are Fc (Ac, Cc, Cc, Dc), the circuit parameters of the output-side two-port network from the current source end of the peak amplifier up until the combining point are Fp (Ap, Bp, Cp, Dp), the load resistance of the carrier amplifier in the state in which it is not backed off is Roptc, the load resistance of the peak amplifier in the state in which it is not backed off is Roptp, m=1+Roptc/Roptp, and the phase difference between the phase of the current source of the carrier amplifier and the phase of the current source of the peak amplifier is θ, within a band of the received signal that is the target for the local device, the relationships:

$$(5) \quad (Ac \times Dp + Bc \times Cp + Ac \times Cp \times ZL')/(Cc \times Dp + Cp \times Dc + Cc \times Cp \times ZL') = m \times Roptc$$

$$(6) \quad \Delta c/(Cc \times Dp + Cp \times Dc + Cc \times Cp \times ZL') = -Roptc \times e^{j \times \theta}$$

$$(7) \quad \Delta p/(Cc \times Dp + Cp \times Dc + Cc \times Cp \times ZL') = Roptc \times e^{-j \times \theta}$$

and

$$(8) \quad (Ap \times Dc + Bp \times Cc + Ap \times Cc \times ZL')/(Cc \times Dp + Cp \times Dc + Cc \times Cp \times ZL') = 0$$

are satisfied, where $\Delta c = Ac \times Dc - Bc \times Cc$ and $\Delta p = Ap \times Dp - Bp \times Cp$.

Some embodiments are directed to a method for determining circuit parameters of a Doherty amplifier. The Doherty amplifier may include, but is not limited to, an input terminal, an output terminal, a splitter, a combiner, a carrier amplifier, and a peak amplifier. The splitter connects to the input terminal. The splitter has first and second outputs. The combiner connects to the output terminal. The combiner has first and second inputs. The carrier amplifier includes a first input-side two-port network connected to the first output of the splitter, a first amplifier connected to an output of the first input-side two-port network, and a first output-side two-port network connected between an output of the first amplifier and the first input of the combiner. The peak amplifier includes a second input-side two-port network connected to the second output of the splitter, a second amplifier connected to the output of the second input-side two-port network, and a second output-side two-port network connected between an output of the second amplifier and the second input of the combiner. The method may include determining circuit parameters between the output terminal and a combining point of the Doherty amplifier so that the combiner is a parallel-connected load type having a parallel connection of the output-side two-port network of the carrier amplifier and the output-side two-port network of the peak amplifier for the output terminal at a combining point, and that a load admittance at the combining point is expressed using a complex number.

If the load admittance at the combining point is YL', the circuit parameters of the output-side two-port network from the current source end of the carrier amplifier up until the combining point are Fc (Ac, Cc, Cc, Dc), the circuit parameters of the output-side two-port network from the current source end of the peak amplifier up until the combining point are Fp (Ap, Bp, Cp, Dp), the load resistance of the carrier amplifier in the state in which it is not backed off is Roptc, the load resistance of the peak amplifier in the state in which it is not backed off is Roptp, m=1+Roptc/Roptp, and the phase difference between the phase of the current source of the carrier amplifier and the phase of the current source of the peak amplifier is θ, within a band of the received signal that is the target for the local device, the relationships:

$$(1) \quad (Ac \times Dp + Bc \times Cp + Ac \times Cp \times YL')/(Cc \times Dp + Cp \times Dc + Cc \times Cp \times YL') = m \times Roptc$$

$$(2) \quad \Delta c/(Cc \times Dp + Cp \times Dc + Cc \times Cp \times YL') = -Roptc \times e^{j \times \theta}$$

$$(3) \quad \Delta p/(Cc \times Dp + Cp \times Dc + Cc \times Cp \times YL') = Roptc \times e^{-j \times \theta}$$

and

$$(4) \quad (Ap \times Dc + Bp \times Cc + Ap \times Cc \times YL')/(Cc \times Dp + Cp \times Dc + Cc \times Cp \times YL') = 0$$

are satisfied, where $\Delta c = Ac \times Dc - Bc \times Cc$ and $\Delta p = Ap \times Dp - Bp \times Cp$.

There are methods for determining circuit parameters of a Doherty amplifier. The Doherty amplifier may include, but is not limited to, an input terminal, an output terminal, a splitter, a combiner, a carrier amplifier, and a peak amplifier. The splitter connects to the input terminal. The splitter has first and second outputs. The combiner connects to the output terminal. The combiner has first and second inputs. The carrier amplifier includes a first input-side two-port network connected to the first output of the splitter, a first amplifier connected to an output of the first input-side two-port network, and a first output-side two-port network connected between an output of the first amplifier and the first input of the combiner. The peak amplifier includes a second input-side two-port network connected to the second output of the splitter, a second amplifier connected to the output of the second input-side two-port network, and a second output-side two-port network connected between an output of the second amplifier and the second input of the combier.

The combiner is a series-connected load type, having a series connection of the output-side two-port network of the carrier amplifier and the output-side two-port network of the peak amplifier for the output terminal at a combining point. The load impedance at the combining point is expressed using a complex number.

If the load impedance at the combining point is ZL', the circuit parameters of the output-side two-port network from the current source end of the carrier amplifier up until the combining point are Fc (Ac, Cc, Cc, Dc), the circuit parameters of the output-side two-port network from the current source end of the peak amplifier up until the combining point are Fp (Ap, Bp, Cp, Dp), the load resistance of the carrier amplifier in the state in which it is not backed off is Roptc, the load resistance of the peak amplifier in the state in which it is not backed off is Roptp, m=1+Roptc/Roptp, and the phase difference between the phase of the current source of the carrier amplifier and the phase of the current source of the peak amplifier is $\theta$, within a band of the received signal that is the target for the local device, and the method determines the circuit parameters of the circuit included between the combining point and the output terminal so that the relationships

$$(5) \quad (Ac \times Dp + Bc \times Cp + Ac \times Cp \times ZL')/(Cc \times Dp + Cp \times Dc + Cc \times Cp \times ZL') = m \times Roptc$$

$$(6) \quad \Delta c/(Cc \times Dp + Cp \times Dc + Cc \times Cp \times ZL') = -Roptc \times e^{j \times \theta}$$

$$(7) \quad \Delta p/(Cc \times Dp + Cp \times Dc + Cc \times Cp \times ZL') = Roptc \times e^{-j \times \theta}$$

and

$$(8) \quad (Ap \times Dc + Bp \times Cc + Ap \times Cc \times ZL')/(Cc \times Dp + Cp \times Dc + Cc \times Cp \times ZL') = 0$$

are satisfied, where $\Delta c = Ac \times Dc - Bc \times Cc$ and $\Delta p = Ap \times Dp - Bp \times Cp$.

A Doherty amplifier will be described below, with references made to the drawings.

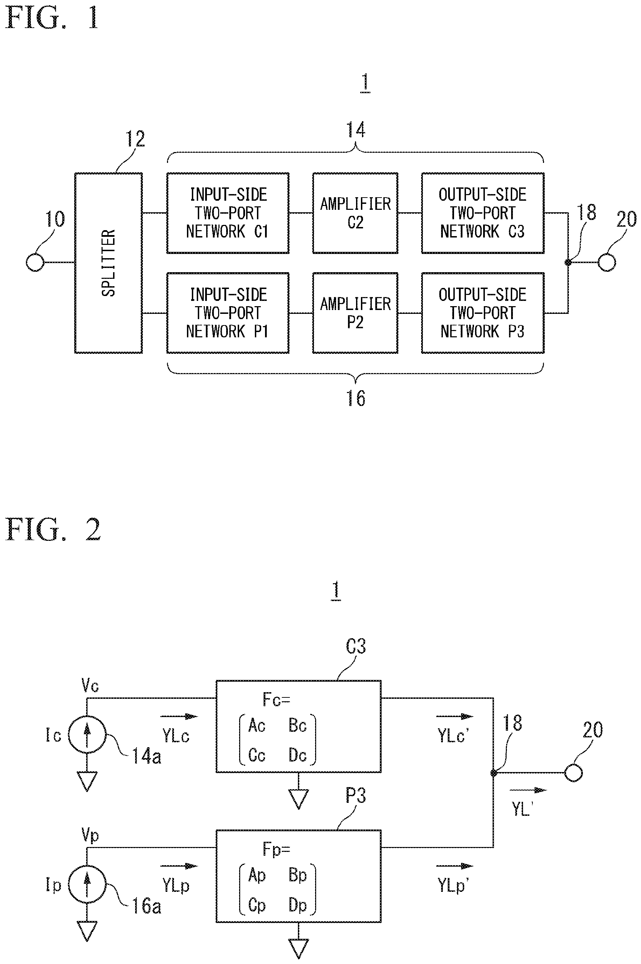

FIG. 1 is a block diagram showing the constitution of a Doherty amplifier 1 of the embodiment not covered by the claimed invention. The Doherty amplifier 1 shown in FIG. 1 includes a parallel-connected load type constitution. In the Doherty amplifier 1, a high frequency signal input to the input terminal 10 is amplified and output from the output terminal 20.

The Doherty amplifier 1 includes an input terminal 10, a splitter 12, a carrier amplifier 14, a peak amplifier 16, a combiner 18, and an output terminal 20. The carrier amplifier 14 includes an input-side two-port network C1, an amplifier element C2, and an output-side two-port network C3. The peak amplifier 16 includes an input-side two-port network P1, an amplifier element P2, and an output-side two-port network P3.

A high frequency signal is supplied to the input terminal 10 as an input signal. The high frequency signal is, for example, a signal in the radio frequency (RF) band. The high frequency signal supplied to the input terminal 10 is output to the splitter 12.

The input-sided two-port network C1, the output-side two-port network C3, the input-side two-port network P1, and the output-side two-port network P3 includes, for example, circuits that are formed on the substrate and are combinations of inductors and capacitors. In addition to inductors and capacitors, the input-sided two-port network C1, the output-side two-port network C3, the input-side two-port network P1, and the output-side two-port network P3 may include circuit characteristics optimized by resistors.

The splitter 12 is connected to the input terminal 10 and distributes the high frequency signal to the carrier amplifier 14 and the peak amplifier 16. The high frequency signal amplified by the carrier amplifier 14 and the peak amplifier 16 are power combined in the combiner 18, and output as the output signal from the output terminal 20.

The carrier amplifier 14 is a cascade-connected circuit of the input-side two-port network C1, the amplifier element C2, and the output-side two-port network C3. The amplifier element C2 is, for example, a field effect transistor (FET). The FET, for example, includes its source terminal connected to a ground terminal and a high frequency signal input to the gate terminal from the input-side two-port network C1, and outputs an amplified high frequency signal from the drain terminal to the output-side two-port network C3. The amplifier element C2, for example, includes a gate bias voltage applied thereto so that the FET is operated as a class AB or class B amplifier, and the FET is operated to amplify from a low-power high frequency signal.

The peak amplifier 16 is a cascade-connected circuit of the input-side two-port network P1, the amplifier element P2, and the output-side two-port network P3. The amplifier element P2 is, for example, an FET, includes its source terminal connected to the ground terminal and a high frequency signal input to the gate terminal from the input-side two-port network P1, and outputs an amplified high frequency signal from the drain terminal to the output two-port network P3. The amplifier element P2, for example, includes a gate bias voltage applied thereto so that the FET operates as a class C amplifier, so that the peak amplifier 16 starts amplification operation when a high frequency signal having an amplitude (power value) exceeding a prescribed value is supplied.

In the parallel-connected load type constitution, considering existing Doherty amplifiers, the output-side two-port network C3 includes an odd number of IIN stages, and the output-side two-port network P3 includes an even number of IIN stages (including zero stages). If the number of IIN stages of the output-side two-port network C3 is one more than the number of IIN stages of the output-side two-port network P3, this is a Doherty amplifier, and if it is one fewer, this is referred to as an inverted Doherty amplifier. The Doherty amplifier 1 may incude an output-side two-port network C3 with a number of IIN stages that is one more than the number of IIN stages of the output-side two-port network P3, and may be what is called an inverted Doherty amplifier that includes less IIN stages. The splitter 12, the input-side two-port network C1, and the input-side two-port network P1 adjust the phase so that the output signal of the carrier amplifier 14 and the output signal of the peak amplifier 16 that are combined at the combiner 18 are in-phase.

FIG. 2 is an equivalent circuit of the output side of the Doherty amplifier 1 of the embodiment not covered by the claimed invention. The current from the current source 14a of the amplifier element C2 is Ic, the voltage thereof is Vc, and the current from the current source 16a of the amplifier element P2 is Ip, and the voltage thereof is Vp. The F parameter of the output-side two-port network C3 is Fc (with elements Ac, Bc, Cc, and Dc), and the F parameter of the output-side two-port network P3 is Fp (with elements Ap, Bp, Cp, and Dp). In this case, the parasitic reactances such as the output capacitances of the amplifier element C2 and the amplifier element P2 are included Fc and Fp.

The relationships between Vc, Vp, Ic, and Ip at the ends of the current source 14a and 16a in FIG. 2 are expressed by Equations (1) to (6). In the Equation (3), Equation (4), Equation (5), and Equation (6) below, the load admittance YL' at the combiner 18 (combining point) is expressed as a complex value. That is, in the Doherty amplifier 1 of the embodiment not covered by the claimed invention, the circuit parameters from the signal output terminal of the carrier amplifier 14 at which the high frequency signal is supplied up to the combiner 18 and the circuit parameters from the signal output terminal of the peak amplifier 16 at which a high frequency signal is supplied up to the combiner 18 are established so as to have an admittance (complex admittance) expressed by a complex value. That is, in the Doherty amplifier 1 of the embodiment not covered by the claimed invention, rather than circuit parameters expressed as real numbers as in existing Doherty amplifiers, the circuit parameters are determined so as to expand to a complex admittance expressed by complex values.

$$Vc = Kcc \times Ic + Kcp \times Ip \qquad \text{Equation (1)}$$

$$Vp = Kpp \times Ip + Kpc \times Ic \qquad \text{Equation (2)}$$

$$Kcc = (Ac \times Dp + Bc \times Cp + Bc \times Dp \times YL')/(Cc \times Dp + Cp \times Dc + Dc \times Dp \times YL') \qquad \text{Equation (3)}$$

$$Kcp = \Delta c/(Cc \times Dp + Cp \times Dc + Dc \times Dp \times YL') \qquad \text{Equation (4)}$$

$$Kpc = \Delta p/(Cc \times Dp + Cp \times Dc + Dc \times Dp \times YL') \qquad \text{Equation (5)}$$

$$Kpp = (Ap \times Dc + Bp \times Cc + Bp \times Dc \times YL')/(Cc \times Dp + Cp \times Dc + Dc \times Dp \times YL') \qquad \text{Equation (6)}$$

In the above, $\Delta c = Ac \times Dc - Bc \times Cc$ and $\Delta p = Ap \times Dp - Bp \times Cp$.

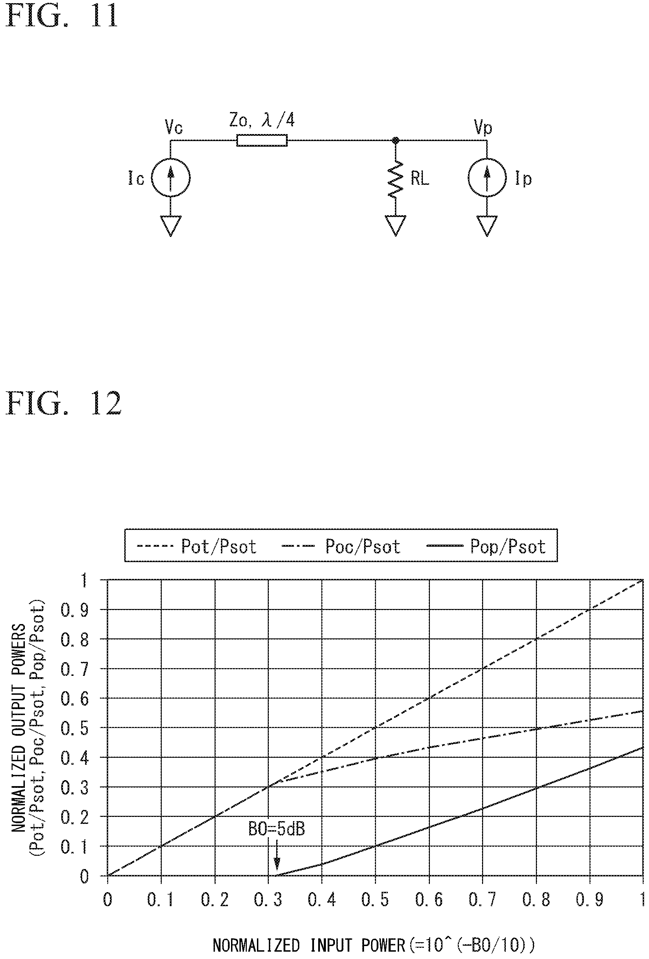

In this case, the voltages and currents at the ends of the current sources 14a and 16a in the Doherty amplifier 1 of the embodiment not covered by the claimed invention are compared with those in a Doherty amplifier of a comparison example. FIG. 11 is the basic equivalent circuit of a parallel-connected load type Doherty amplifier of the comparison example. In the Doherty amplifier of the comparison example, there are no parasitic reactance such as output capacitances in the amplifier element of the carrier amplifier and the amplifier element of the peak amplifier. The output-side two-port network in the carrier amplifier is a distributed constant line having an electrical length of $\lambda/4$ (1/4 wavelength) with characteristic impedance of Zo. There is no output-side two-port network in the peak amplifier, and the amplifier element of the peak amplifier is directly coupled to the combiner. In FIG. 11, Ic, Vc, Ip, and Vp are the same current source end voltages and currents as in FIG. 2, and the load admittance YL'=1/RL is a pure conductance.

In the Doherty amplifier 1 of the embodiment not covered by the claimed invention, if BO=0, meaning that there is no back-off, f the current of the current source 14a of the amplifier element C2 in the carrier amplifier 14 is Isc, the optimum load resistance is Roptc, the current of the current source 16a of the amplifier element P2 in the peak amplifier 16 is Isp, and the optimum load resistance is Roptp, then m - 1 = Roptc/Roptp = Isp/Isc. Zo=Roptc, RL=Roptc/m, and $\theta$ is the phase difference between the peak amplifier current source phase and the carrier amplifier current source phase, the input side being optimized so that the peak amplifier 16 starts amplifying operation when this is, for example, $\pi/2$, at BO=20 $\times \log_{10}$ (m). In this case, in the range $0 \leq Ic \leq Isc/m$, the peak amplifier 16 is in the off state, in which it does not amplify, and the output power of Vc, Vp, Ic, Ip and the carrier amplifier 14, the output power of the peak amplifier 16, and the total output power are expressed by the following equations.

$$Ic = Isc \times 10^{-BO/20}$$

$$Ip = 0$$

$$Vc = m \times Roptc \times Ic$$

$$= m \times Roptc \times Isc \times 10^{-BO/20}$$

$$Vp = Roptc \times e^{-j \times \theta} \times Ic$$

$$= Roptc \times e^{-j \times \theta} \times Isc \times 10^{-BO/20}$$

Carrier amplifier 14 output power: $Poc = m \times Roptc \times Isc^2 \times 10^{-BO/10}$
Peak amplifier 16 output power: $Pop = 0$
Total output power: $Pot = m \times Roptc \times Isc^2 \times 10^{-BO/10}$

In the range $Isc/m \leq Ic \leq Isc$, the peak amplifier 16 is in the on condition, in which it amplifies, and Vc, Vp, Ic, Ip, the output power of the carrier amplifier 14, the output power of the peak amplifier 16, and the total output power are expressed by the following equations.

$$Ic = Isc \times 10^{-BO/20} \qquad \text{Equation (7)}$$

$$Ip = e^{-j \times \theta} \times (m \times Ic - Isc)$$

$$= e^{-j \times \theta} \times Isc \times (m \times 10^{-BO/20} - 1) \qquad \text{Equation (8)}$$

$$Vc = m \times Roptc \times Ic - Roptc \times e^{-j \times \theta} \times Ip$$

$$= Roptc \times Isc \qquad \text{Equation (9)}$$

$$Vp = Roptc \times e^{-j \times \theta} \times Ic$$

$$= Roptc \times e^{-j \times \theta} \times Isc \times 10^{-BO/20} \qquad \text{Equation (10)}$$

Carrier amplifier 14 output power: $Poc = Roptc \times Isc \times Ic$
Peak amplifier 16 output power: $Pop = Roptc \times (m \times Ic^2 - Isc \times Ic)$
Total output power: $Pot = m \times Roptc \times Isc^2 \times 10^{-BO/10}$

With the output power of the Doherty amplifier 1 for the case in which BO = 0 dB as $Psot = m \times Roptc \times Isc_2$, and if, for example, the peak amplifier 16 starts amplifying operation at m=1.782, meaning it starts amplifying at BO=5 dB, if each output power is normalized for input power dependency, the results are as shown in FIG. 12. FIG. 12 shows the relationship between the reference input power, the normalized total output power, the output power of the carrier amplifier 14, and the output power of the peak amplifier 16. According to FIG. 12, the total output power Pot is proportional to the input power over the entire range. From a small signal having a low input power up until BO=5 dB, the peak amplifier 16 is in the off state and the output power Poc of the carrier amplifier 14 is proportional to the input power. When the input power exceeds BO=5 dB, the output power Poc of the carrier amplifier 14 is proportional to the square root of the input power, and the output power Pop of the peak amplifier 16 that goes into the on state is Pot - Poc.

In the case in which, if Equation (1) and Equation (2), which express the relationship between Vc, Vp, Ic and Ip at the ends of the current sources 14a and 16a in the Doherty amplifier 1 of the embodiment when the load admittance YL' is a complex value, are equal to Equation (9) and Equation (10), which express the relationship between Vc, Vp, Ic and Ip in the comparison example when the load admittance YL' is a pure conductance (1/RL), in the Doherty amplifier of the comparison example, the output power Poc of the carrier amplifier 14 in the Doherty amplifier 1 of the embodiment, the output power Pop of the peak amplifier 16, and the total output power Pot have the characteristics shown in FIG. 12.

If the Vc, Vp, Ic, and Ip of Equation (7) to Equation (10) are substituted into Vc, Vp, Ic, and Ip of Equation (1) and Equation (2) and the result is rearranged, Kcc and Kpp are expressed by the following equations.

$$Kcc + Kcp \times e^{-j \times \theta} \times (m - 10^{BO/20}) = Roptc \times 10^{BO/20}$$

$$Kpp \times e^{-j\times\theta} \times 10^{-BO/20} \times (m - 10^{BO/20}) + Kpc \times 10^{-BO/20} = Roptc \times e^{-j\times\theta} \times$$

$$10^{-BO/20}$$

The conditions under which the above apply for an arbitrary BO, and within the band of the received signal that is the target for the local device, are the following Equation (11) to Equation (14).

$$Kcc = (Ac \times Dp + Bc \times Cp + Bc \times Dp \times YL') / (Cc \times Dp + Cp \times Dc + Dc \times Dp$$

$$\times YL') = m \times Roptc$$

$$Equation\ (11)$$

$$Kcp = \Delta c/(Cc \times Dp + Cp \times Dc + Dc \times Dp \times YL') = - Roptc \times e^{j\times\theta}$$

$$Equation\ (12)$$

$$Kpc = \Delta p/(Cc \times Dp + Cp \times Dc + Dc \times Dp \times YL') = Roptc \times e^{-j\times\theta}$$

$$Equation\ (13)$$

$$Kpp = ((Ap \times Dc + Bp \times Cc + Bp \times Dc \times YL')/(Cc \times Dp + Cp \times Dc + Dc \times Dp \times$$

$$YL') = 0 \qquad\qquad Equation\ (14)$$

Even if Fc and Fp are reciprocal lossless two-port networks, because the total degree of freedom is 8, one complex admittance solution exists for the four complex number equations, Equation (11) to Equation (14) with respect to the complex admittance YL'.

As described above, because the Doherty amplifier 1 expands the load admittance from a real value to a complex value, it is possible to expand the design space from real values to complex values, thereby increasing the degree of design freedom and enabling a broadband design.

Next, a specific constitution in the above-described Doherty amplifier 1 will be described.

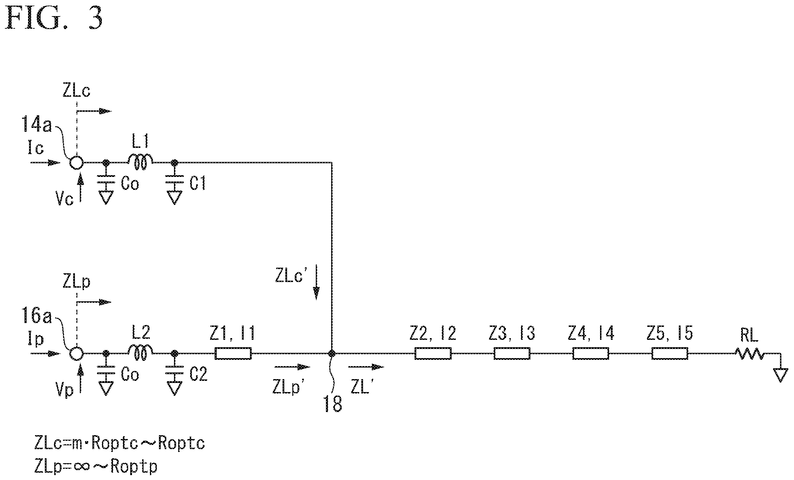

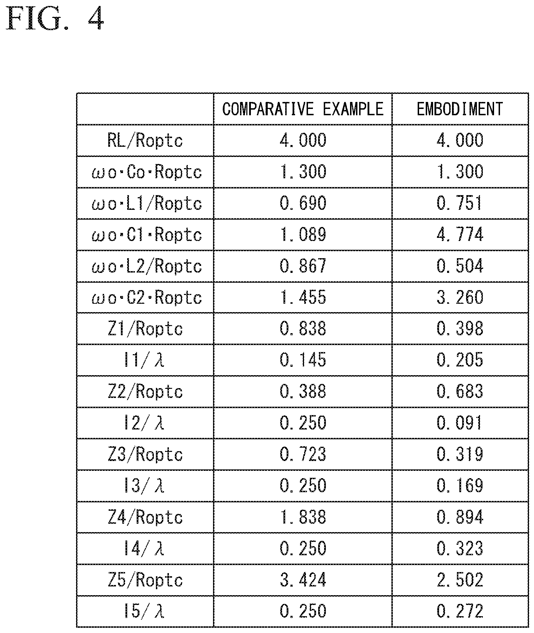

FIG. 3 is a circuit diagram showing a part of the parallel-connected load type constitution in the Doherty amplifier 1 of the embodiment not covered by the claimed invention. FIG. 4 is a drawing showing the setting of the circuit elements included in the parallel-connected load type Doherty amplifier 1 in the embodiment not covered by the claimed invention. The Doherty amplifier 1 shown in FIG. 3 is shown as the constitution from the end of the current source 14a of the carrier amplifier 14 and the end of the current source 16a of the peak amplifier 16 up until the load RL. The impedance between the load RL side and the end of the current source 14a of the carrier amplifier 14 will be made ZLc and the impedance between the load RL and the end of the current source 16a of the peak amplifier 16 will be made ZLp.

A $\pi$-configured circuit is connected to the end of the current source 14a of the carrier amplifier 14 and the end of the current source 16a of the peak amplifier 16. The Co of the $\pi$-configured circuit connected to the carrier amplifier 14 is the output capacitance of the FET in the carrier amplifier 14. The Co of the $\pi$-configured circuit connected to the peak amplifier 16 is the output capacitance of the FET in the peak amplifier 16. The peak amplifier 16 has connected thereto, in addition to the $\pi$-configured circuit, a distributed constant line having a characteristic impedance Z1 and also a length 11. When this circuit corresponds to the case of the load admittance being a pure conductance, such as the Doherty amplifier of the comparison example, the Doherty amplifier is a parallel-connected load type inverted Doherty amplifier in which the carrier amplifier 14 side includes one stage of IIN ($\pi$-configured circuit) and the peak amplifier 16 side includes two stages of IIN ($\pi$-configured circuit and Z1).

The load impedance of the carrier amplifier 14 at the combiner 18 will be made ZLc', the load impedance of the peak amplifier 16 at the combiner 18 will be made ZLp', and the impedance between the load RL side and the combiner 18 (combining point) will be made ZL'. A two-port network that converts from the impedance ZL' to the inductance of the load RL is disposed between the combiner 18 and the load RL. This two-port network includes a line having a length of l2 and a characteristic impedance of Z2, a line having a length of l3 and a characteristic impedance of Z3, a line having a length of l4 and a characteristic impedance of Z4, and a line having a length of l5 and a characteristic impedance of Z5. This impedance converting circuit may be a lumped constant circuit rather than a distributed constant line.

The values at various parts in a Doherty amplifier 1 such as noted above, are set, for example, as shown in FIG. 4. The values shown in FIG. 4 are set so as to supply a high frequency signal to the load RL with good efficiency in a state in which a high frequency signal of a prescribed frequency band is input to the Doherty amplifier 1.

The setting example shown in FIG. 4 has the following setting conditions (1) to (4).

$$(1) \qquad \omega o \times Co \times Roptc = 1.3$$

$$(2) \qquad RL/Roptc = 4$$

$$(3) \qquad m = 1 + n = 1.78$$

$$(4) \qquad BO = 20 \times \log_{10} (m) = 5 \text{ dB (turn the peak amplifier 16 on at a}$$

back-off of 5 dB)

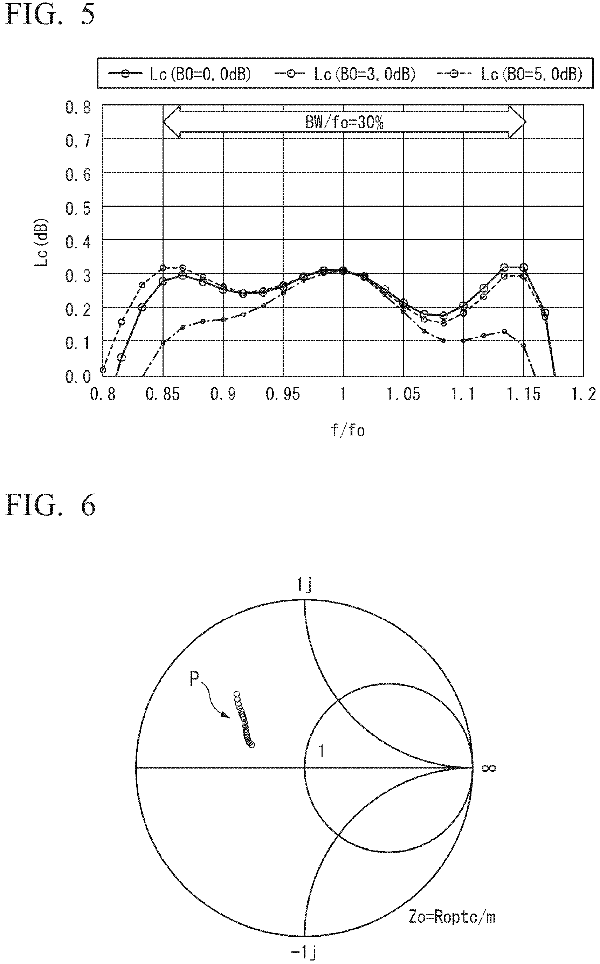

In the constitution shown in FIG. 3, the Doherty amplifier 1 set as shown in FIG. 4 has the frequency characteristics shown in FIG. 5. FIG. 5 shows the relationship, in the Doherty amplifier 1 of the embodiment, at each back-off value, between the frequency (f/fo) and the combined loss $Lc=10 \times \log_{10}$ (ideal Pot/calculated Pot) defined by the ratio of the ideal and calculated the output power Pot.

In FIG. 5, fo is a prescribed basic frequency, and f is the frequency of the high frequency signal input to the Doherty amplifier 1. According to FIG. 5, in the frequency band in which f/fo is from 0.85 to 1.15, the combined loss Lc of the high frequency signal is in the range of approximately 0.1 to 0.3 dB. This combined loss Lc is 0.317 dB or lower. The frequency band in which f/fo is from 0.85 to 1.15 corresponds to a bandwidth of 30% with respect to the frequency fo.

FIG. 6 is a Smith chart (impedance chart) showing the load impedance ZL'=1/YL' between the load RL side and the combiner 18 (combining point) in the Doherty amplifier 1. According to FIG. 6, the plot P that represents the load impedance ZL' of the Doherty amplifier 1 moves away from the real axis and is broadens to include the imaginary value region. From this, by making the load a complex impedance (complex admittance), the Doherty amplifier 1 includes the combined loss Lc with the good frequency characteristics shown in FIG. 5. That is, in the Doherty amplifier 1 the circuit parameters from the combiner 18 up to the load RL are determined so that the load admittance between the load RL and the output terminal 20 and the combiner 18 is a complex value.

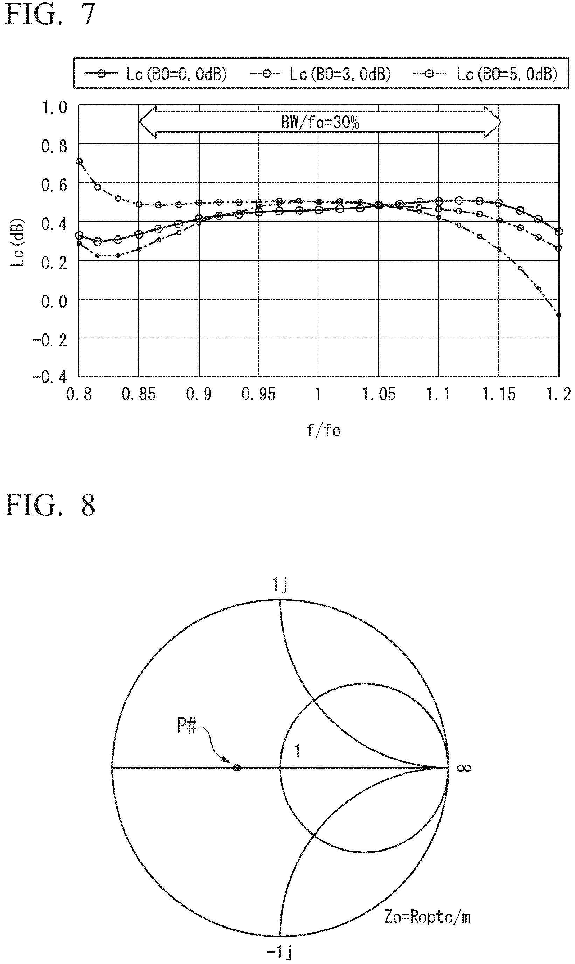

FIG. 7 shows the frequency characteristics of the Doherty amplifier of a comparison example. FIG. 8 is a Smith cart showing the load impedance ZL' in a Doherty amplifier of the comparison example. The value of various parts in FIG. 3 are set in the Doherty amplifier of the comparison example to be different from those of the Doherty amplifier 1 of the embodiment as shown in FIG. 4.

According to FIG. 8, with the Doherty amplifier of the comparison example, the load impedance is plotted at P# on the real axis. As shown in FIG. 7, in the frequency band range in which f/fo is from 0.85 to 1.15, the high frequency signal combined loss Lc is in the range of approximately 0.2 to 0.5 dB, and at less than 0.503 dB, the combined loss is approximately 0.2 dB worse than in FIG. 5.

If the Doherty amplifier 1 of the embodiment not covered by the claimed invention is compared to the Doherty amplifier of the comparison example, in contrast to the Doherty amplifier of the comparison example, which is limited to the real axis of the Smith cart, with the Doherty amplifier 1 of the embodiment not covered by the claimed invention, the design space is broadened to encompass a wide range of complex impedance that is away from the real axis, enabling a good combined loss Lc having the frequency characteristics as shown in FIG. 5.

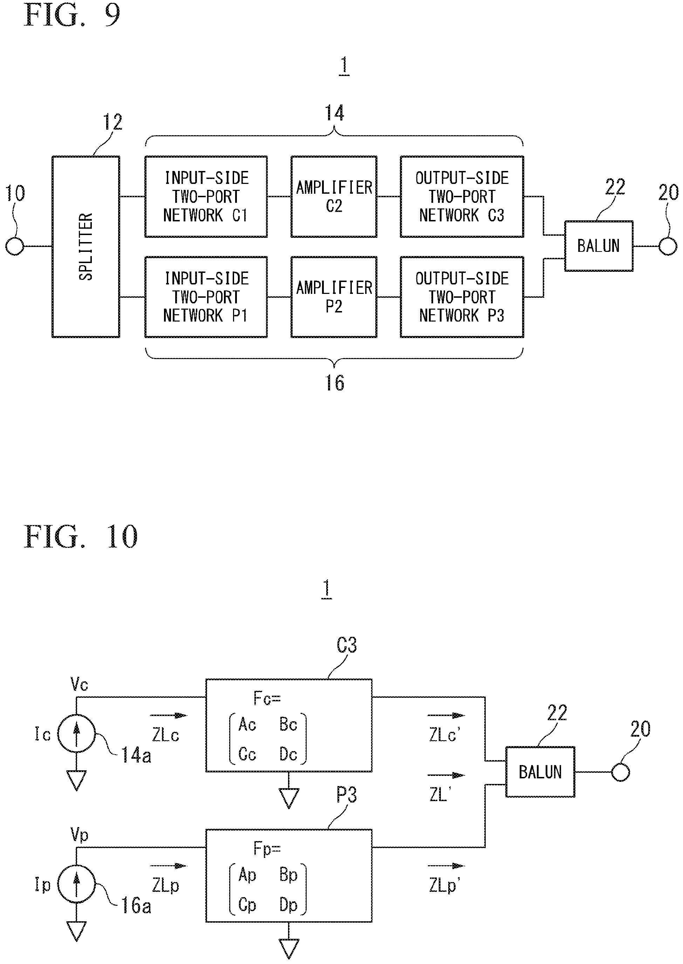

Next, the series-connected load type constitution in the Doherty amplifier 1 of an embodiment according to the claimed invention will be described. FIG. 9 is a block diagram showing the series-connected load type constitution of the Doherty amplifier 1 of the embodiment according to the claimed invention.

As shown in FIG. 9, this Doherty amplifier 1 includes a converter such as a balun 22. The balun 22 may perform as a converter that converts a high frequency signal between a balanced line and an unbalanced type line. The converter will hereinafter be referred to as "balun". The balun 22, for example, includes one end connected to the output-side two-port network C3 and P3 and the other end connected to the output terminal 20. In the Doherty amplifier 1 the output-side two-port network C3, the output-side two-port network P3, and the output terminal 20 are connected in series. The other parts of FIG. 9 are the same as in FIG. 1.

Because of this series-connected load type constitution, in the case of an existing Doherty amplifier, there are an even number of IIN stages (including zero) in the output-side two-port network C3 and an odd number of IIN stages in the output-side two-port network P3. If the number of IIN stages of the output-side two-port network C3 is fewer than the number of IIN stages of the output-side two-port network P3, this is a Doherty amplifier, and if it is one more, this is referred to as an inverted Doherty amplifier. The splitter 12, the input-side two-port network C1, and the input-side two-port network P1 adjust the phase so that the outputs of the carrier amplifier 14 and the peak amplifier 16 are inverted phases at the input end of the balun 22.

FIG. 10 is a drawing of the equivalent circuit of the output side of the series-connected load type Doherty amplifier 1 of the embodiment according to the claimed invention. In the description to follow, although the admittance Y will be indicated converted to the impedance Z, the definitions of othe symbols are the same as in FIG. 2.

The relationships between Vc, Vp, Ic, and Ip at the ends of the current sources 14a and 16a in FIG. 10 are expressed by the following Equation (15) to Equation (20).

$$ Vc = Kcc \times Ic + Kcp \times Ip \qquad \text{Equation (15)} $$

$$ Vp = Kpp \times Ip + Kpc \times Ic \qquad \text{Equation (16)} $$

$$ Kcc = (Ac \times Dp + Bc \times Cp + Ac \times Cp \times ZL') / (Cc \times Dp + Cp \times Dc + Cc \times Cp \times ZL') \qquad \text{Equation (17)} $$

$$ Kcp = \Delta c/(Cc \times Dp + Cp \times Dc + Cc \times Cp \times ZL') \qquad \text{Equation (18)} $$

$$ Kpc = \Delta p/(Cc \times Dp + Cp \times Dc + Cc \times Cp \times ZL') \qquad \text{Equation (19)} $$

$$ Kpp = (Ap \times Dc + Bp \times Cc + Ap \times Cc \times ZL')/(Cc \times Dp + Cp \times Dc + Cc \times Cp \times ZL') \qquad \text{Equation (20)} $$

In the above, $\Delta c = Ac \times Dc - Bc \times Cc$ and $\Delta p = Ap \times Dp - Bp \times Cp$.

The end voltages and currents of the current sources 14a and 16a in the series-connected load type Doherty amplifier 1 are compared with the voltages and currents at the current source end in the Doherty amplifier of the comparison example.

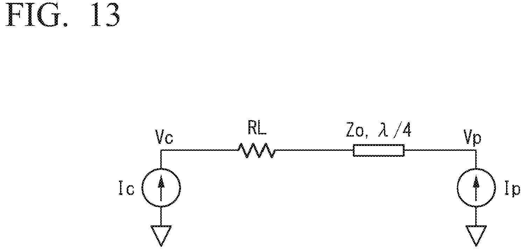

FIG. 13 shows the basic equivalent circuit of the series-connected load type Doherty amplifier of the comparison example. FIG. 13 shows the amplifier element of the carrier amplifier as a current source that outputs the current Ic and shows the amplifier element of the peak amplifier as a current source that outputs the current Ip. According to FIG. 13, the parasitic reactances such as the output capacitances of the amplifier element in the carrier amplifier and the amplifier element in the peak amplifier are ignored. The output-side two-port network in the peak amplifier is a distributed constant line having a characteristic impedance of Zo and an electrical length of λ/4 (1/4 wavelength). The carrier amplifier is not connected to the output-side two-port network, but is directly connected to the load RL. Ic, Vc, Ip, and Vp at the ends of the current sources are the same as in FIG. 10, and the load inductance is ZL'=RL, which is a pure resistance.

Symbols such as Isc are the same as in FIG. 11, which shows the parallel-connected load type Doherty amplifier, Zo=Roptc, RL=m × Roptc, θ=π/2, and the input side is optimized so that the peak amplifier starts amplifying operation when $BO=20 \times 10_{10}$ (m). In this case, Vc, Vp, Ic, Ip, the output power of the carrier amplifier 14, the output power of the peak amplifier 16, and the total output power are expressed by the following equations.

In the range $0 \le Ic \le Isc/m$, the peak amplifier is in the off state, in which it does not amplify, and:

$$ Ic = Isc \times 10^{-BO/20} $$

$$Ip = 0$$

$$Vc = m \times Roptc \times Ic$$

$$= m \times Roptc \times Iscc \times 10^{-BO/20}$$

$$Vp = Roptc \times e^{-j\times\theta} \times Ic$$

$$= Roptc \times e^{-j\times\theta} \times Isc \times 10^{-BO/20}$$

Carrier amplifier output power: $Poc = m \times Roptc \times Isc^2 \times 10^{-BO/10}$
Peak amplifier output power: $Pop = 0$
Total output power: $Pot = m \times Roptc \times Isc^2 \times 10^{-BO/10}$

In the range $Isc/m \leq Ic \leq Isc$, the peak amplifier is in the on state, in which it amplifies, and Vc, Vp, Ic, Ip, the output power of the carrier amplifier 14, the output power of the peak amplifier 16, and the total output power are expressed by the following equations.

$$Ic = Isc \times 10^{-BO/20} \qquad\qquad \text{Equation (21)}$$

$$Ip = e^{-j\times\theta} \times (m \times Ic - Isc)$$

$$= e^{-j\times\theta} \times Isc \times (m \times 10^{-BO/20} - 1) \quad \text{Equation (22)}$$

$$Vc = m \times Roptc \times Ic - Roptc \times e^{j\times\theta} \times Ip$$

$$= Roptc \times Isc \qquad\qquad \text{Equation (23)}$$

$$Vp = Roptc \times e^{-j\times\theta} \times Ic$$

$$= Roptc \times e^{-j\times\theta} \times Isc \times 10^{-BO/20} \qquad \text{Equation (24)}$$

Carrier amplifier output power: $Poc = Roptc \times Isc \times Ic$
Peak amplifier output power: $Pop = Roptc \times (m \times Ic^2 - Isc \times Ic)$
Total output power: $Pot = m \times Roptc \times Isc^2 \times 10^{-BO/10}$

From the above equations, the series-connected load type Doherty amplifier 1 has the same characteristics as the parallel-connected load type Doherty amplifier. Therefore, the normalized input-output characteristics such as shown in FIG. 12 are the same for the series-connected load type Doherty amplifier 1 of the embodiment according to the claimed invention as they are for the parallel-connected load type Doherty amplifier of the embodiment not covered by the claimed invention described above.

If the Vc, Vp, Ic, and Ip of Equation (21) to Equation (24) are substituted into Vc, Vp, Ic, and I of Equation (15) and Equation (16) and the result is rearranged, Kcc and Kcp are expressed by the following equations.

$$Kcc + Kcp \times e^{-j\times\theta} \times (m - 10^{BO/20}) = Roptc \times 10^{BO/20}$$

$$Kpp \times e^{-j\times\theta} \times 10^{-BO/20} \times (m - 10^{-BO/20}) + Kpc \times 10^{-BO/20} = Roptc \times e^{-j\times\theta} \times$$

$$10^{-BO/20}$$

The conditions under which the above apply for an arbitrary BO are as follows.

$$Kcc = (Ac \times Dp + Bc \times Cp + Ac \times Cp \times ZL')/(Cc \times Dp + Cp \times Dc + Cc \times Cp \times ZL') = m \times Roptc \qquad \text{Equation (25)}$$

$$Kcp = \Delta c/(Cc \times Dp + Cp \times Dc + Cc \times Cp \times ZL') = -Roptc \times e^{-j\times\theta}$$
$$\text{Equation (26)}$$

$$Kpc = \Delta p/(Cc \times Dp + Cp \times Dc + Cc \times Cp \times ZL') = Roptc \times e^{-j\times\theta}$$
$$\text{Equation (27)}$$

$$Kpp = (Ap \times Dc + Bp \times Cc + Ap \times Cc \times ZL') / (Cc \times Dp + Cp \times Dc + Cc \times Cp \times ZL') = 0 \qquad \text{Equation (28)}$$

Even if Fc and Fp are reciprocal lossless two-port networks, because the total degree of freedom is 8, one solution exists for the four complex number equations in Equation (25) to Equation (28) with respect to ZL.

As described above, because the series-connected load type Doherty amplifier 1 of the embodiment according to the claimed invention can expand the load impedance from a real value to a complex value, it is possible to expand the design space from real values to complex values, thereby increasing the degree of design freedom and enabling a broadband design.

The Doherty amplifier (1) described above includes a carrier amplifier (14) that icludes the splitter (12) connected to the input terminal (10), the combiner (18) connected to the output terminal (20), the input-side two-port network (C1) connected to one output terminal of the splitter (12), the amplifier element (C2) connected to the output terminal of the input-side two-port network (C1), and the output-side two-port network (C3) connected between the output terminal of the amplifier element (C2) and one input terminal of the combiner (18); and a peak amplifier (16) that includes the input-side two-port network (P1) connected to the other output terminal of the splitter (12), the amplifier element (P2) connected to the output terminal of the input-side two-port network (PI), and the output-side two-port network (P3) connected between the output terminal of the amplifier element (P2) and the other input terminal of the combiner (18), wherein, the combiner (18) is a parallel-connected load type having a parallel connection of the output-side two-port network (C3) of the carrier amplifier (14) and the output-side two-port network (P3) of the peak amplifier (16) for the output terminal (20) at a combining point (18), wherein a load admittance at the combining point (18) is expressed using a complex number..

In the Doherty amplifier (1), if the load admittance at the combining point (18) is YL', the circuit parameters of the output-side two-port network (C3) from the current source end of the peak amplifier (16) up to the combining point (18) are Fc (Ac, Bc, Cc, Dc), the circuit parameters of the output-side two-port network (C3) from the current source end of the carrier amplifier (14) up to the combining point (18) are Fp (Ap, Bp, Cp, Dp), the load resistance of the carrier amplifier (14) in the state in which it is not backed off is Roptc, the load resistance of the peak amplifier (16) in the state in which it is not backed off is Roptp, m=1+Roptc/Roptp, and the phase difference between the phase of the current source of the carrier amplifier (14) and the phase of the current source of the peak amplifier (16) is $\theta$, within a band of the received signal that is the target for the local device, the following relationships (1) to (4) are satisfied.

$$(1) \qquad (Ac \times Dp + Bc \times Cp + Bc \times Dp \times YL')/(Cc \times Dp + Cp \times Dc + Dc \times Dp \times YL') = m \times Roptc$$

$$(2) \qquad \Delta c/(Cc \times Dp + Cp \times Dc + Dc \times Dp \times YL') = -Roptc \times e^{j\times\theta}$$

$$(3) \qquad \Delta p/(Cc \times Dp + Cp \times Dc + Dc \times Dp \times YL') = Roptc \times e^{-j\times\theta}$$

$$(4) \quad (Ap \times Dc + Bp \times Cc + Bp \times Dc \times YL')/(Cc \times Dp + Cp \times Dc + Dc \times Dp \times YL') = 0$$

In the above, $\Delta c = Ac \times Dc - Bc \times Cc$ and $\Delta p = Ap \times Dp - Bp \times Cp$.

The Doherty amplifier (1) describe above includes a carrier amplifier (14) that includes the splitter (12) connected to the input terminal (10), the combiner (18) connected to the output terminal (20), the input-side two-port network (C1) connected to one output terminal of the splitter (12), the amplifier element (C2) connected to the output terminal of the input-side two-port network (C1), and the output-side two-port network (C3) connected between the output terminal of the amplifier element (C2) and one input terminal of the combiner (18); and a peak amplifier (16) that includes the input-side two-port network (P1) connected to the other output terminal of the splitter (12), the amplifier element (P2) connected to the output terminal of the input-side two-port network (PI), and the output-side two-port network (P3) connected between the output terminal of the amplifier element (P2) and the other input terminal of the combiner (18), wherein the combiner (18) is a series-connected load type, having a series connection of the output-side two-port network (C3) of the carrier amplifier (14) and the output-side two-port network (P3) of the peak amplifier (16) for the output terminal (20) at a combining point (18), wherein the load impedance (ZL') at the output-side two-port network (C3) of the carrier amplifier (14) and the output-side two-port network (P3) of the peak amplifier (16) is a complex value.

In the Doherty amplifier (1), if the load impedance at the output-side two-port network (C3) of the carrier amplifier (14) and the output-side two-port network (P3) of the peak amplifier (16) at the combiner (18) is ZL', the circuit parameters of the output-side two-port network (C3) from the current source end of the carrier amplifier (14) up until the combiner (18) are Fc (Ac, Cc, Cc, Dc), the circuit parameters of the output-side two-port network (P3) from the current source end of the peak amplifier (16) up until the combining point (22) areFp (Ap, Bp, Cp, Dp), the load resistance of the carrier amplifier (14) in the state in which it is not backed off is Roptc, the load resistance of the peak amplifier (16) in the state in which it is not backed off is Roptp, m=1+Roptc/Roptp, and the phase difference between the phase of the current source of the carrier amplifier (14) and the phase of the current source of the peak amplifier (16) is $\theta$, within a band of the received signal that is the target for the local device, the following relationships (5) to (8) are satisfied.

$$(5) \quad (Ac \times Dp + Bc \times Cp + Ac \times Cp \times ZL')/(Cc \times Dp + Cp \times Dc + Cc \times Cp \times ZL') = m \times Roptc$$

$$(6) \quad \Delta c/(Cc \times Dp + Cp \times Dc + Cc \times Cp \times ZL') = -Roptc \times e^{j \times \theta}$$

$$(7) \quad \Delta p/(Cc \times Dp + Cp \times Dc + Cc \times Cp \times ZL') = Roptc \times e^{-j \times \theta}$$

$$(8) \quad (Ap \times Dc + Bp \times Cc + Ap \times Cc \times ZL')/(Cc \times Dp + Cp \times Dc + Cc \times Cp \times ZL') = 0$$

In the above, $\Delta c = Ac \times Dc - Bc \times Cc$ and $\Delta p = Ap \times Dp - Bp \times Cp$.

An embodiment not covered by the claimed invention is a method for determining the circuit parameters of a Dohert amplifier (1) having a carrier amplifier (14) that has the splitter (12) connected to the input terminal (10), the combiner (18) connected to the output terminal (20), the input-side two-port network (C1) connected to one output terminal of the splitter (12), the amplifier element (C2) connected to the output terminal of the input-side two-port network (C1), and the output-side two-port network (C3) connected between the output terminal of the amplifier element (C2) and one input terminal of the combiner (18); and a peak amplifier (16) that includes the input-side two-port network (P1) connected to the other output terminal of the splitter (12), the amplifier element (P2) connected to the output terminal of the input-side two-port network (PI), and the output-side two-port network (P3) connected between the output terminal of the amplifier element (P2) and the other input terminal of the combiner (18), wherein, with the combiner (18) as the combining point and as a parallel-connected load type with the output-side two-port network (C3) of the peak amplifier (14) and the output-side two-port network (P3) of the peak amplifier (16) connected in parallel with respect to the output terminal (20), the method determines the circuit parameters between the combining point and the output terminal (20) so that the load admittance at the combining point is a complex value.

If the load admittance at the combining point (18) is YL', the circuit parameters of the output-side two-port network (C3) from the current source end of the carrier amplifier (14) up to the combining point (18) are Fc (Ac, Bc, Cc, Dc), the circuit parameters of the output-side two-port network (C3) from the current source end of the peak amplifier (16) up to the combining point (18) are Fp (Ap, Bp, Cp, Dp), the load resistance of the carrier amplifier (14) in the state in which it is not backed off is Roptc, the load resistance of the peak amplifier (16) in the state in which it is not backed off is Roptp, m=1+Roptc/Roptp, and the phase difference between the phase of the current source of the carrier amplifier (14) and the phase of the current source of the peak amplifier (16) is θ, within a band of the received signal that is the target for the local device, the embodiment determined the circuit parameters of the circuit included between the combining point (18) and the output terminal (20) so that the following relationships (1) to (4) are satisfied.

$$(1) \quad (Ac \times Dp + Bc \times Cp + Bc \times Dp \times YL')/(Cc \times Dp + Cp \times Dc + Dc \times Dp \times YL') = m \times Roptc$$

$$(2) \quad \Delta c/(Cc \times Dp + Cp \times Dc + Dc \times Dp \times YL') = -Roptc \times e^{j \times \theta}$$

$$(3) \quad \Delta p/(Cc \times Dp + Cp \times Dc + Dc \times Dp \times YL') = Roptc \times e^{-j \times \theta}$$

$$(4) \quad (Ap \times Dc + Bp \times Cc + Bp \times Dc \times YL')/(Cc \times Dp + Cp \times Dc + Dc \times Dp \times YL') = 0$$

In the above, $\Delta c = Ac \times Dc - Bc \times Cc$ and $\Delta p = Ap \times Dp - Bp \times Cp$.

There is a further method for determining the circuit parameters of a Doherty amplifier (1) having a carrier amplifier (14) that has the spliter (12) connected to the input terminal (10), the combiner (18) connected to the output terminal (20), the input-side two-port network (C1) connected to one output terminal of the splitter (12), the amplifier element (C2) connected to the output terminal of the input-side two-port network (C1), and the output-side two-port network (C3) connected between the output terminal of the amplifier element (C2) and one input terminal of the combiner (18); and a peak amplifier (16) that includes the input-side two-port network (P1) connected to the other output terminal of the splitter (12), the amplifier element (P2) connected to the output terminal of the input-side two-port network (PI), and the output-side two-port network (P3) connected between the output terminal of the amplifier element (P2) and the other input terminal of the combiner (18), wherein, the combiner (18) is a series-connected load type, having a series connection of the output-side two-port network (P3) of the carrier amplifier (14) and the output-side two-port network (P3) of the peak amplifier (16) for the output terminal(20) at a combining point (18) The load impedance at the combining point (18) is expressed using a complex number.

If the load impedance at the combining point (18) is ZL', the circuit parameters of the output-side two-port network (C3) from the current source end of the carrier amplifier (14) up until the combining point (18) are Fc (Ac, Cc, Cc, Dc), the circuit parameters of the output-side two-port network (P3) from the current source end of the peak amplifier (16) up until the combining point (18) are Fp (Ap, Bp, Cp, Dp), the load resistance of the carrier amplifier (14) in the state in which it is not backed off is Roptc, the load resistance of the peak amplifier (16) in the state in which it is not backed off is Roptp, m=1+Roptc/Roptp, and the phase difference between the phase of the current source of the carrier amplifier (14) and the phase of the current source of the peak amplifier (16) is θ, within a band of the received signal that is the target for the local device, nd the method determines the circuit parameters of the circuit included between the combining point (18) and the output terminal (20) so that the relationships

$$(5) \quad (Ac \times Dp + Bc \times Cp + Ac \times Cp \times ZL')/(Cc \times Dp + Cp \times Dc + Cc \times Cp \times ZL') = m \times Roptc$$

$$(6) \quad \Delta c/(Cc \times Dp + Cp \times Dc + Cc \times Cp \times ZL') = -Roptc \times e^{j \times \theta}$$

$$(7) \qquad \Delta p/(Cc \times Dp + Cp \times Dc + Cc \times Cp \times ZL') = Roptc \times e^{-j \times \theta}$$

$$(8) \qquad (Ap \times Dc + Bp \times Cc + Ap \times Cc \times ZL')/(Cc \times Dp + Cp \times Dc + Cc \times Cp \times ZL') = 0$$

are satisfied, where $\Delta c = Ac \times Dc - Bc \times Cc$ and $\Delta p = Ap \times Dp - Bp \times Cp$.

According to at least one of the above-described embodiments, by expanding the load impedance from real values to complex values, it is possible to efficiently amplify a high frequency signal in the case of back-off over a broad frequency band.

While certain embodiments of the present invention have been described, these embodiments have been presented by way of example only, and are not intended to limit the scope of the invention. Indeed, the novel embodiments described herein may be embodied in a variety of other forms, and various omissions, substitutions and changes in the form of the embodiments described herein may be made without departing from the scope of the invention. The accompanying claims are intended to cover such forms or modifications as would fall within the scope of the invention.

**Claims**

1. A Doherty amplifier (1) comprising:

an input terminal (10);
an output terminal (20);
a splitter (12) connected to the input terminal (10), the splitter (12) having first and second outputs;
a combiner (18) connected to the output terminal (20), the combiner (18) having first and second inputs;
a carrier amplifier (14) including a first input-side two-port network connected to the first output of the splitter (12), a first amplifier (C2) connected to an output of the first input-side two-port network, and a first output-side two-port network (C3) connected between an output of a current source (14a) of the first amplifier (C2) and the first input of the combiner (18); and
a peak amplifier (16) including a second input-side two-port network connected to the second output of the splitter (12), a second amplifier (P2) connected to the output of the second input-side two-port network, and a second output-side two-port network (P3) connected between an output of a current source (16a) of the second amplifier and the second input of the combiner (18),
wherein the combiner (18) is a series-connected load type, as a balun (22) which includes one end connected to the output-side two-port networks (C3, P3) of the carrier amplifier and the peak amplifier, and the other end connected to the output terminal (20), having a series connection of the output-side two-port network (C3) of the carrier amplifier (14) and the output-side two-port network (P3) of the peak amplifier (16) with the output terminal (20); wherein
a load impedance at the combiner (18) as the balun (22) at the output-side two-port network of the carrier amplifier (14) and at the output-side two-port network of the peak amplifier (16) is expressed using a complex number; and **characterised by** the Doherty amplifier (1) being so configured that,
if the load impedance at the combiner (18) is ZL', if the F parameters of the output-side two-port network (C3) from the current source (14a) output of the carrier amplifier (14) up until the combiner (18) are Fc (Ac, Bc, Cc, Dc), if the parameters of the output-side two-port network (P3) from the current source (16a) output of the peak amplifier (16) up until the combiner (18) are Fp (Ap, Bp, Cp, Dp), if the load resistance of the carrier amplifier (14) in the state in which it is not backed off is Roptc, if the load resistance of the peak amplifier (16) in the state in which it is not backed off is Roptp, m=1+Roptc/Roptp, and if the phase difference between the phase of the current source (14a) of the carrier amplifier (14) and the phase of the current source (16a) of the peak amplifier (16) is $\theta$, then within a transmission frequency band of the receiving signal of the Doherty amplifier (1), the relationships:

$$(Ac \times Dp + Bc \times Cp + Ac \times Cp \times ZL')/(Cc \times Dp + Cp \times Dc + Cc \times Cp \times ZL') = m \times Roptc \angle ;$$

$$\Delta c/(Cc \times Dp + Cp \times Dc + Cc \times Cp \times ZL') = -Roptc \times e^{jx} \qquad ;$$

$$\Delta p/(Cc \times Dp + Cp \times Dc + Cc \times Cp \times ZL') = Roptc \times e^{-jx\theta} \qquad ;$$

and

$$(Ap \times Dc + Bp \times Cc + Ap \times Cc \times ZL')/(Cc \times Dp + Cp \times Dc + Cc \times Cp \times ZL') = 0$$

are satisfied, where $\Delta c = Ac \times Dc - Bc \times Cc$ and $\Delta p = Ap \times Dp - Bp \times Cp$.

2. A method for determining circuit parameters of a Doherty amplifier comprising: an input terminal; an output terminal; a splitter connected to the input terminal, the splitter having first and second outputs; a combiner connected to the output terminal, the combiner having first and second inputs; a carrier amplifier (14) including a first input-side two-port network connected to the first output of the splitter, a first amplifier connected to an output of the first input-side two-port network, and a first output-side two-port network (C3) connected between an output of a current source of the first amplifier and the first input of the combiner; and a peak amplifier (16) including a second input-side two-port network connected to the second output of the splitter, a second amplifier connected to the output of the second input-side two-port network, and a second output-side two-port network (P3) connected between an output of a current source of the second amplifier and the second input of the combiner, wherein the combiner is a series-connected load type, as a balun which includes one end connected to the output-side two-port networks of the carrier amplifier and the peak amplifier, and the other end connected to the output terminal, having a series connection of the output-side two-port network (C3) of the carrier amplifier (14) and the output-side two-port network (P3) of the peak amplifier (16) with the output terminal (20), wherein a load impedance at the combiner (18) as the balun (22) at the output-side two-port network of the carrier amplifier (14) and at the output-side two-port network of the peak amplifier (16) is expressed using a complex number; **characterised by** comprising determining the circuit parameters of the Doherty amplifier so that, if the load impedance at the combiner (18) is ZL', if the F parameters of the output-side two-port network from the current source output of the carrier amplifier (14) up until the combiner (18) are Fc (Ac, Bc, Cc, Dc), if the F parameters of the output-side two-port network from the current source output of the peak amplifier (16) up until the combiner (18) are Fp (Ap, Bp, Cp, Dp), if the load resistance of the carrier amplifier in the state in which it is not backed off is Roptc, if the load resistance of the peak amplifier (16) in the state in which it is not backed off is Roptp, m=1+Roptc/Roptp, and if the phase difference between the phase of the current source of the carrier amplifier (14) and the phase of the current source of the peak amplifier (16) is θ, then the F parameters between the combiner (18) and the output terminal are determined so that within a transmission frequency band of the receiving signal of the Doherty amplifier, the relationships:

$$(Ac \times Dp + Bc \times Cp + Ac \times Cp \times ZL')/(Cc \times Dp + Cp \times Dc + Cc \times Cp \times ZL') =$$
$$m \times Roptc \qquad ;$$

$$\Delta c/(Cc \times Dp + Cp \times Dc + Cc \times Cp \times ZL') = -Roptc \times e^{jx} \qquad ;$$

$$\Delta p/(Cc \times Dp + Cp \times Dc + Cc \times Cp \times ZL') = Roptc \times e^{-jx\theta} \qquad ;$$

and

$$(Ap \times Dc + Bp \times Cc + Ap \times Cc \times ZL')/(Cc \times Dp + Cp \times Dc + Cc \times Cp \times ZL') = 0$$

are satisfied, where $\Delta c = Ac \times Dc - Bc \times Cc$ and $\Delta p = Ap \times Dp - Bp \times Cp$.

**Patentansprüche**

1.  Ein Doherty-Verstärker (1) umfassend:

    einen Eingangsanschluss (10);
    einen Ausgangsanschluss (20);
    einen Teiler (12), der mit dem Eingangsanschluss (10) verbunden ist, wobei der Teiler (12) einen ersten und einen zweiten Ausgang aufweist;
    einen Kombinierer (18), der mit dem Ausgangsanschluss (20) verbunden ist, wobei der Kombinierer (18) einen ersten und einen zweiten Eingang aufweist;
    einen Trägerverstärker (14) mit einem ersten eingangsseitigen Zwei-Port-Netzwerk, das mit dem ersten Ausgang des Teilers (12) verbunden ist, einem ersten Verstärker (C2), der mit einem Ausgang des ersten eingangsseitigen Zwei-Port-Netzwerks verbunden ist, und einem ersten ausgangsseitigen Zwei-Port-Netzwerk (C3), das zwischen einem Ausgang einer Stromquelle (14a) des ersten Verstärkers (C2) und dem ersten Eingang des Kombinierers (18) angeschlossen ist; und
    einen Spitzenverstärker (16) mit einem zweiten eingangsseitigen Zwei-Port-Netzwerk, das mit dem zweiten Ausgang des Teilers (12) verbunden ist, einem zweiten Verstärker (P2), der mit dem Ausgang des zweiten eingangsseitigen Zwei-Port-Netzwerks verbunden ist, und einem zweiten ausgangsseitigen Zwei-Port-Netzwerk (P3), das zwischen einem Ausgang einer Stromquelle (16a) des zweiten Verstärkers und dem zweiten Eingang des Kombinierers (18) angeschlossen ist,
    wobei der Kombinierer (18) ein in Reihe geschalteter Lasttyp ist, als ein Balun (22), der ein Ende enthält, das mit den ausgangsseitigen Zwei-Port-Netzwerken (C3, P3) des Trägerverstärkers und des Spitzenverstärkers verbunden ist, und das andere Ende, das mit dem Ausgangsanschluss (20) verbunden ist, mit einer Reihenschaltung des ausgangsseitigen Zwei-Port-Netzwerks (C3) des Trägerverstärkers (14) und des ausgangsseitigen Zwei-Port-Netzwerks (P3) des Spitzenverstärkers (16) mit dem Ausgangsanschluss (20);
    wobei eine Lastimpedanz am Kombinierer (18) als Balun (22) am ausgangsseitigen Zwei-Port-Netzwerk des Trägerverstärkers (14) und am ausgangsseitigen Zwei-Port-Netzwerk des Spitzenverstärkers (16) unter Verwendung einer komplexen Zahl ausgedrückt wird; und **dadurch gekennzeichnet, dass** der Doherty-Verstärker (1) so konfiguriert ist, dass, wenn die Lastimpedanz am Kombinierer (18) ZL' ist, wenn die F-Parameter des ausgangsseitigen Zwei-Port-Netzwerks (C3) von der Stromquelle (14a) am Ausgang des Trägerverstärkers (14) bis zum Kombinierer (18) Fc (Ac, Bc, Cc, Dc) sind, wenn die F-Parameter des ausgangsseitigen Zwei-Port-Netzwerks (P3) von der Stromquelle (16a) Ausgang des Spitzenverstärkers (16) bis zum Kombinierer (18) Fp (Ap, Bp, Cp, Dp) sind, wenn der Lastwiderstand des Trägerverstärkers (14) im nicht abgesenkten Zustand Roptc ist, wenn der Lastwiderstand des Spitzenverstärkers (16) im nicht abgesenkten Zustand Roptp ist, m=1+Roptc/Roptp, und wenn die Phasendifferenz zwischen der Phase der Stromquelle (14a) des Trägerverstärkers (14) und der Phase der Stromquelle (16a) des Spitzenverstärkers (16) θ ist, dann gelten innerhalb eines Sendefrequenzbandes des Empfangssignals des Doherty-Verstärkers (1) die Beziehungen:

    $$(Ac \times Dp + Bc \times Cp + Ac \times Cp \times ZL')/(Cc \times Dp + Cp \times Dc + Cc \times Cp \times ZL') = m \times Roptc;$$

    $$\Delta c/(Cc \times Dp + Cp \times Dc + Cc \times Cp \times ZL') = -Roptc \times e^{j \times \theta};$$

    $$\Delta p/(Cc \times Dp + Cp \times Dc + Cc \times Cp \times ZL') = Roptc \times e^{-j \times \theta};$$

    and

    $$(Ap \times Dc + Bp \times Cc + Ap \times Cc \times ZL')/(Cc \times Dp + Cp \times Dc + Cc \times Cp \times ZL') = 0$$

erfüllt sind, wobei $\Delta c = Ac \times Dc - Bc \times Cc$ and $\Delta p = Ap \times Dp - Bp \times Cp$.

2. Ein Verfahren zum Bestimmen von Schaltungsparametern eines Doherty-Verstärkers, umfassend: einen Eingangsanschluss; einen Ausgangsanschluss; einen mit dem Eingangsanschluss verbundenen Teiler, wobei der Teiler einen ersten und einen zweiten Ausgang aufweist; einen mit dem Ausgangsanschluss verbundenen Kombinierer, wobei der Kombinierer einen ersten und einen zweiten Eingang aufweist; einen Trägerverstärker (14), der ein erstes eingangsseitiges Zwei-Port-Netzwerk, das mit dem ersten Ausgang des Teilers verbunden ist, einen ersten Verstärker, der mit einem Ausgang des ersten eingangsseitigen Zwei-Port-Netzwerks verbunden ist, und ein erstes ausgangsseitiges Zwei-Port-Netzwerk (C3), das zwischen einem Ausgang einer Stromquelle des ersten Verstärkers und dem ersten Eingang des Kombinierers angeschlossen ist, umfasst und einen Spitzenverstärker (16) mit einem zweiten eingangsseitigen Zwei-Port-Netzwerk, das mit dem zweiten Ausgang des Verteilers verbunden ist, einem zweiten Verstärker, der mit dem Ausgang des zweiten eingangsseitigen Zwei-Port-Netzwerks verbunden ist, und einem zweiten ausgangsseitigen Zwei-Port-Netzwerk (P3), das zwischen einem Ausgang einer Stromquelle des zweiten Verstärkers und dem zweiten Eingang des Kombinierers angeschlossen ist,
wobei der Kombinierer ein in Reihe geschalteter Lasttyp ist, als ein Balun, der ein Ende enthält, das mit den ausgangsseitigen Zwei-Port-Netzwerken des Trägerverstärkers und des Spitzenverstärkers verbunden ist, und das andere Ende mit dem Ausgangsanschluss verbunden ist, mit einer Reihenschaltung des ausgangsseitigen Zwei-Port-Netzwerks (C3) des Trägerverstärkers (14) und des ausgangsseitigen Zwei-Port-Netzwerks (P3) des Spitzenverstärkers (16) mit dem Ausgangsanschluss (20), wobei eine Lastimpedanz an dem Kombinierer (18) als Balun (22) an dem ausgangsseitigen Zwei-Port-Netzwerk des Trägerverstärkers (14) und an dem ausgangsseitigen Zwei-Port-Netzwerk des Spitzenverstärkers (16) unter Verwendung einer komplexen Zahl ausgedrückt wird **dadurch gekennzeichnet, dass** sie die Schaltungsparameter des Doherty-Verstärkers so bestimmt, dass,
wenn die Lastimpedanz am Kombinierer (18) ZL' ist, wenn die F-Parameter des ausgangsseitigen Zwei-Port-Netzwerks vom Stromquellenausgang des Trägerverstärkers (14) bis zum Kombinierer (18) Fc (Ac, Bc, Cc, Dc) sind, wenn die F-Parameter des ausgangsseitigen Zwei-Port-Netzwerks vom Stromquellenausgang des Spitzenverstärkers (16) bis zum Kombinierer (18) Fp (Ap, Bp, Cp, Dp) sind, wenn der Lastwiderstand des Trägerverstärkers im nicht abgesenkten Zustand Roptc ist, wenn der Lastwiderstand des Spitzenverstärkers (16) im nicht abgesenkten Zustand Roptp ist, m=1+Roptc/Roptp, und wenn die Phasendifferenz zwischen der Phase der Stromquelle des Trägerverstärkers (14) und der Phase der Stromquelle des Spitzenverstärkers (16) θ ist, dann werden die F-Parameter zwischen dem Kombinierer (18) und dem Ausgangsanschluss so bestimmt, dass innerhalb eines Sendefrequenzbandes des Empfangssignals des Doherty-Verstärkers die Beziehungen:

$$(Ac \times Dp + Bc \times Cp + Ac \times Cp \times ZL')/(Cc \times Dp + Cp \times Dc + Cc \times Cp \times ZL') = m \times Roptc;$$

$$\Delta c/(Cc \times Dp + Cp \times Dc + Cc \times Cp \times ZL') = -Roptc \times e^{j \times \theta};$$

$$\Delta p/(Cc \times Dp + Cp \times Dc + Cc \times Cp \times ZL') = Roptc \times e^{-j \times \theta};$$

and

$$(Ap \times Dc + Bp \times Cc + Ap \times Cc \times ZL')/(Cc \times Dp + Cp \times Dc + Cc \times Cp \times ZL') = 0$$

erfüllt sind, wobei $\Delta c = Ac \times Dc - Bc \times Cc$ and $\Delta p = Ap \times Dp - Bp \times Cp$.

## Revendications

1. Amplificateur Doherty (1) comprenant :

    une borne d'entrée (10) ;
    une borne de sortie (20) ;
    un séparateur (12) connecté à la borne d'entrée (10), le séparateur (12) présentant des première et seconde sorties ;

un combineur (18) connecté à la borne de sortie (20), le combineur (18) présentant des première et seconde entrées ;

un amplificateur de porteuse (14) incluant un premier réseau à deux ports côté entrée connecté à la première sortie du séparateur (12), un premier amplificateur (C2) connecté à une sortie du premier réseau à deux ports côté entrée, et un premier réseau à deux ports côté sortie (C3) connecté entre une sortie d'une source de courant (14a) du premier amplificateur (C2) et la première entrée du combineur (18) ; et

un amplificateur de crête (16) incluant un second réseau à deux ports côté entrée connecté à la seconde sortie du séparateur (12), un second amplificateur (P2) connecté à la sortie du second réseau à deux ports côté entrée, et un second réseau à deux ports côté sortie (P3) connecté entre une sortie d'une source de courant (16a) du second amplificateur et la seconde entrée du combineur (18),

dans lequel le combineur (18) est un type de charge connecté en série, comme symétriseur (22) qui inclut une extrémité connectée aux réseaux à deux ports côté sortie (C3, P3) de l'amplificateur de porteuse et de l'amplificateur de crête, et l'autre extrémité connectée à la borne de sortie (20),

présentant une connexion en série du réseau à deux ports côté sortie (C3) de l'amplificateur de porteuse (14) et du réseau à deux ports côté sortie (P3) de l'amplificateur de crête (16) à la borne de sortie (20) ;

dans lequel une impédance de charge au niveau du combineur (18), comme le symétriseur (22) au niveau du réseau à deux ports côté sortie de l'amplificateur de porteuse (14) et au niveau du réseau à deux ports côté sortie de l'amplificateur de crête (16), est exprimée en utilisant un nombre complexe ; et

**caractérisé en ce que** l'amplificateur Doherty (1) est configuré de telle sorte que,

si l'impédance de charge au niveau du combineur (18) est ZL', si les paramètres F du réseau à deux ports côté sortie (C3) provenant de la sortie de la source de courant (14a) de l'amplificateur de porteuse (14) jusqu'au combineur (18) sont Fc (Ac, Bc, Cc, Dc), si les paramètres F du réseau à deux ports côté sortie (P3) provenant de la sortie de la source de courant (16a) de l'amplificateur de crête (16) jusqu'au combineur (18) sont Fp (Ap, Bp, Cp, Dp), si la résistance de charge de l'amplificateur de porteuse (14) dans l'état dans lequel il n'est pas reculé est Roptc, si la résistance de charge de l'amplificateur de crête (16) dans l'état dans lequel il n'est pas reculé est Roptp, m = 1 + Roptc/Roptp, et si la différence de phase entre la phase de la source de courant (14a) de l'amplificateur de porteuse (14) et la phase de la source de courant (16a) de l'amplificateur de crête (16) est $\theta$, alors dans une bande de fréquence de transmission du signal de réception de l'amplificateur Doherty (1), les relations :

$$(Ac \times Dp + Bc \times Cp + Ac \times Cp \times ZL')/(Cc \times Dp + Cp \times Dc + Cc \times Cp \times ZL') = m \times Roptc ;$$

$$\Delta c/(Cc \times Dp + Cp \times Dc + Cc \times Cp \times ZL') = -Roptc \times e^{jx} ;$$

$$\Delta p/(Cc \times Dp + Cp \times Dc + Cc \times Cp \times ZL') = Roptc \times e^{-jx\theta} ;$$

et

$$(Ap \times Dc + Bp \times Cc + Ap \times Cc \times ZL')/(Cc \times Dp + Cp \times Dc + Cc \times Cp \times ZL') = 0$$

sont satisfaites, où $\Delta c = Ac \times Dc - Bc \times Cc$ et $\Delta p = Ap \times Dp - Bp \times Cp$.

2. Procédé de détermination des paramètres de circuit d'un amplificateur Doherty comprenant : une borne d'entrée ; une borne de sortie ; un séparateur connecté à la borne d'entrée, le séparateur présentant des première et seconde sorties ; un combineur connecté à la borne de sortie, le combineur présentant des première et seconde entrées ; un amplificateur de porteuse (14) incluant un premier réseau à deux ports côté entrée connecté à la première sortie du séparateur, un premier amplificateur connecté à une sortie du premier réseau à deux ports côté entrée, et un premier réseau à deux ports côté sortie (C3) connecté entre une sortie d'une source de courant du premier amplificateur et la première entrée du combineur ; et un amplificateur de crête (16) incluant un second réseau à deux ports côté entrée connecté à la seconde sortie du séparateur, un second amplificateur connecté à la sortie du second réseau à deux ports côté entrée, et un second réseau à deux ports côté sortie (P3) connecté entre une sortie d'une source de courant du second amplificateur et la seconde entrée du combineur, dans lequel le combineur est du type à charge connectée en série, qui inclut une extrémité connectée aux réseaux à deux ports côté sortie de l'amplificateur de porteuse et de l'amplificateur de crête, et l'autre extrémité connectée à la borne de sortie, présentant une connexion en série du réseau à deux ports côté sortie (C3) de l'amplificateur de porteuse (14) et du réseau à deux ports côté sortie (P3) de l'amplificateur de crête (16) à la borne de sortie (20), dans lequel une impédance de charge au niveau du combineur (18), comme le symétriseur (22) au niveau du réseau à deux ports côté sortie de l'amplificateur de porteuse (14) et au niveau du réseau à deux ports côté sortie de l'amplificateur de crête (16), est exprimée en utilisant un nombre complexe ;

**caractérisé en ce qu'**il comprend la détermination des paramètres de circuit de l'amplificateur Doherty de sorte que, si l'impédance de charge au niveau du combineur (18) est ZL', si les paramètres F du réseau à deux ports côté sortie provenant de la sortie de la source de courant de l'amplificateur de porteuse (14) jusqu'au combineur (18) sont Fc (Ac, Bc, Cc, Dc), si les paramètres F du réseau à deux ports côté sortie provenant de la sortie de la source de courant de l'amplificateur de crête (16) jusqu'au combineur (18) sont Fp (Ap, Bp, Cp, Dp), si la résistance de charge de l'amplificateur de porteuse dans l'état dans lequel il n'est pas reculé est Roptc, si la résistance de charge de l'amplificateur de crête (16) dans l'état dans lequel il n'est pas reculé est Roptp, m = 1 + Roptc/Roptp, et si la différence de phase entre la phase de la source de courant de l'amplificateur de porteuse (14) et la phase de la source de courant de l'amplificateur de crête (16) est θ, alors les paramètres F entre le combineur (18) et la borne de sortie sont déterminés de sorte que dans une bande de fréquence de transmission du signal de réception de l'amplificateur Doherty, les relations :

$$(Ac \times Dp + Bc \times Cp + Ac \times Cp \times ZL')/(Cc \times Dp + Cp \times Dc + Cc \times Cp \times ZL') = m \times Roptc \ ;$$

$$\Delta c/(Cc \times Dp + Cp \times Dc + Cc \times Cp \times ZL') = -Roptc \times e^{ix} \ ;$$

$$\Delta p/(Cc \times Dp + Cp \times Dc + Cc \times Cp \times ZL') = Roptc \times e^{-jx\theta} \ ;$$

et

$$(Ap \times Dc + Bp \times Cc + Ap \times Cc \times ZL')/(Cc \times Dp + Cp \times Dc + Cc \times Cp \times ZL') = 0$$

sont satisfaites, où $\Delta c = Ac \times De - Bc \times Cc$ et $\Delta p = Ap \times Dp - Bp \times Cp$.

# FIG. 1

# FIG. 2

FIG. 3

ZLc=m·Roptc～Roptc
ZLp=∞～Roptp

FIG. 4

| | COMPARATIVE EXAMPLE | EMBODIMENT |
|---|---|---|
| RL/Roptc | 4.000 | 4.000 |
| $\omega o \cdot Co \cdot Roptc$ | 1.300 | 1.300 |
| $\omega o \cdot L1/Roptc$ | 0.690 | 0.751 |
| $\omega o \cdot C1 \cdot Roptc$ | 1.089 | 4.774 |
| $\omega o \cdot L2/Roptc$ | 0.867 | 0.504 |
| $\omega o \cdot C2 \cdot Roptc$ | 1.455 | 3.260 |
| Z1/Roptc | 0.838 | 0.398 |
| $l1/\lambda$ | 0.145 | 0.205 |
| Z2/Roptc | 0.388 | 0.683 |
| $l2/\lambda$ | 0.250 | 0.091 |
| Z3/Roptc | 0.723 | 0.319 |
| $l3/\lambda$ | 0.250 | 0.169 |
| Z4/Roptc | 1.838 | 0.894 |
| $l4/\lambda$ | 0.250 | 0.323 |
| Z5/Roptc | 3.424 | 2.502 |
| $l5/\lambda$ | 0.250 | 0.272 |

# FIG. 5

# FIG. 6

FIG. 7

FIG. 8

FIG. 9

FIG. 10

# FIG. 11

# FIG. 12

FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015003565 A

- WO 2013133215 A1

**Non-patent literature cited in the description**

- **YARLAGADDA R.K. RAO.** Analog and Digital Signals and Systems. Springer Science & Business Media, 05 October 2010